Europäisches Patentamt

European Patent Office

Office européen des brevets

(19)

(11) Veröffentlichungsnummer: **0 199 309**

**A2**

(12) # EUROPÄISCHE PATENTANMELDUNG

(21) Anmeldenummer: **86105397.3**

(22) Anmeldetag: **18.04.86**

(51) Int. Cl.⁴: **H 05 K 3/36**
**H 01 R 9/09, H 05 K 7/02**

(30) Priorität: **19.04.85 DE 3514264**

(43) Veröffentlichungstag der Anmeldung:
**29.10.86 Patentblatt 86/44**

(84) Benannte Vertragsstaaten:
**AT BE CH DE FR GB IT LI LU NL SE**

(71) Anmelder: **Wilhelm Sedlbauer GmbH**
**Quagliostrasse 6**
**D-8000 München 90(DE)**

(71) Anmelder: **Firma Würth Elektronik GmbH + Co. KG**
**Postfach 15**
**D-7119 Niedernhall(DE)**

(72) Erfinder: **Markovic, Josip**
**Gerstenacker 15**
**D-8352 Grafenau(DE)**

(72) Erfinder: **Willhauk, Walter, Dipl.-Ing.**
**Hohe Strasse 22**
**D-7102 Weinsberg(DE)**

(74) Vertreter: **Seibert, Rudolf, Dipl.-Ing.**
**Rechtsanwälte Seibert & Partner Tattenbachstrasse 9**
**D-8000 München 22(DE)**

(54) **Vielfachschaltelement zum Verbinden einer Mehrzahl von Mehrfachbussen.**

(57) Die Erfindung bezieht sich auf ein Vielfachschaltelement zum Verbinden einer Mehrzahl von durch beispielsweise eine busorientierte Rückwandplatine geführten Mehrfachbussen. Erfindungsgemäß wird zur Verbindung eine mehrlagige Schaltplatine vorgesehen, die gegenseitig eine der Anzahl der zu verknüpfenden Mehrfachbusse entsprechende Anzahl von Steckerleisten aufweist und die im inneren der Anzahl der Busse eines Mehrfachbusses minus 1 entsprechende Anzahl von Querverbindungsleiterlagen in unterschiedlichen Ebenen besitzt, wobei die Leiter einer Querverbindungslage mit jeweils einem der Busse eines Mehrfachbusses durchkontaktiert sind. Gemäß einer vorteilhaften Weiterbildung werden die Querverbindungsleiterlagen bis an den Rand der Platine geführt, um zusätzliche Schaltelemente in die miteinander zu verknüpfenden Busleitungen einschleifen zu können.

Fig.2

Anwaltsakte: 4206

Vielfachschaltelement zum Verbinden
einer Mehrzahl von Mehrfachbussen

Die vorliegende Erfindung bezieht sich auf ein Vielfachschaltelement,
wie es zum Verbinden einer Mehrzahl von insbesondere an Steckerleisten geführte oder aber auch durch eine Verdrahtungsplatine
durchkontaktierte parallel geführte Mehrfachbusse benötigt wird.

In der Mikroelektronik kommt dem Zusammenschalten und der Zusammenarbeit von insbesondere auf Europakarten untergebrachten
Mikroprozessoren und anderen Prozessor-, Speicher- und Peripherieteilen erhöhte Bedeutung zu. Dabei wurde die Verschaltung
der Datenleitung über Verbindungsplatten, auf die die einzelnen
Europakarten gesteckt werden, zwischenzeitlich standardisiert,
d.h. es bestehen im Interesse einwandfreier Datenübertragung zwischen den einzelnen Geräteeinheiten ganz konkrete Vorschriften,
wie die Datenbusse miteinander zu verbinden sind und welche
Kriterien hinsichtlich der Anpassung und/oder des Wellenwiderstandes
einzuhalten sind.

Die standardisierte Größe der Europakarte ermöglicht hierbei im
allgemeinen nur die Verwendung von Bytes bestehend aus 16 Bits,
wobei die 16 parallelen Leitungen in üblicher Terminologie als Bus
angesprochen werden. Da die Interessen der einzelnen Anwender
verschieden sind und gerade in der Mikroelektronik umgekehrt
Sonderanfertigungen unverhältnismäßig aufwendig und teuer sind, ist man dazu übergegangen, jeder einzelnen Europakarte über ihre Anschlüsse insgesamt 3 Busse (Bündel von Leitungen) zuzuordnen, im folgenden Mehrfachbus genannt, wobei die einzelnen Kontakte der 3 Busse in 3 Reihen angeordnet sind und die mittlere Reihe für den Datenaustausch entsprechend der vorgenannten Standardisierung herangezogen wird. Die restlichen beiden Busse stehen dem Anwender zur freien Verschaltung und weiterem Anschluß zur Verfügung.

Da hierbei auch beim Zusammenschalten mehrerer Europakarten notwendigerweise auch diese parallel zum Datenbus angeordneten Leitungsbündel (Busse) im Vielfach geschaltet werden müssen, sind bisher folgende Maßnahmen realisiert worden:

Die einzelnen Europakarten werden in die Verdrahtungsplatine für den Datenbus in herkömmlicher Weise gesteckt, wobei die Anschlüsse des Datenbus untereinander im Vielfach im Rahmen der Verdrahtungsplatine verbunden werden. Die beiden seitlich davon liegenden Busse, die sowohl zur Informationsübertragung als auch Befehlsübertragung, Abspeicherung, usw. je nach dem Wunsch des Anwenders herangezogen werden können, wurden durch die Verdrahtungsplatine hindurchgeführt und auf der Rückseite der Verdrahtungsplatine mit Steckern nach Außen geführt. Auf diese Stecker wurden dann Anschlußleisten gesetzt, die ihrerseits untereinander über ein Flachbandkabel verbunden wurden. Auf diese Weise wird an sich eine einwandfreie Verbindung zwischen den dem Anwender zu seinen Zwecken zur Verfügung stehenden Bussen erreicht. Nachteilig an dieser Technik ist einmal, daß das Flachbandkabel verhältnismäßig nachgiebig ist, so daß ein Aufsetzen und Abziehen der Steckerleisten sowie die Lagerung eines derartigen Vielfachschaltelementes Probleme mit sich bringen.

Man könnte nun daran denken, das Flachbandkabel auf einer entsprechend ausgebildeten steifen Platte zu befestigen, z.B. zu verkleben, um den vorgenannten Nachteil zu beheben.

Die Verwendung eines Flachbandkabels hat aber darüberhinaus noch den Nachteil, daß eine relativ hohe Induktivität gegeben ist, die die Anwendung höherer Frequenzen, die in der modernen Technik aber benötigt werden, ausschließt. So begrenzen derartige Flachbandkabel die Übertragungsfrequenz auf etwa 10 MHz, während in der Praxis jedoch Arbeitsfrequenzen von etwa 20 MHz benötigt werden. Darüberhinaus hat ein Flachbandkabel einen relativ hohen Übersprechfaktor, was zur Verfälschung von Daten führen kann. Außerdem ist über ein Flachbandkabel eine Anpassung des Wellenwiderstandes der einzelnen Leitungen sowie überhaupt das Einschleifen von zusätzlichen Schaltelementen grundsätzlich ausgeschlossen.

Aufgabe der Erfindung ist es dementsprechend, ein Vielfachschaltelement der vorgenannten Gattung und für die vorgenannten Zwecke zu schaffen, das einfach herstellbar und leicht handhabbar ist, bei dem eine gute Kontaktgabe zwischen den einzelnen Anschlüssen mit geringstem Nebensprecheffekt garantiert ist und bei dem zusätzlich die Einschaltung von zusätzlichen Schaltelementen, beispielsweise zur Anpassung des Wellenwiderstandes mit einfachen Mitteln und ohne Auftrennung des Vielfachschaltelementes selbst möglich ist.

Diese Aufgabe wird mit einem Vielfachschaltelement mit den Merkmalen des Patentanspruches 1 gelöst. Vorteilhafte Weiterbildungen ergeben sich aus den Unteransprüchen.

Das Vielfachschaltelement nach der Erfindung wird also in Form einer mehrlagigen Schaltplatine realisiert, die eine der Anzahl der zu verknüpfenden Mehrfachbusse entsprechende Anzahl von Steckerleisten mit soviel Reihen trägt, daß zumindest die Durchkontaktierungen aller Busse eines Mehrfachbusses mit Ausnahme des für den Informationsaustausch entsprechend der Standardisierung vorgesehenen Busses ermöglicht wird. Dabei werden die für die Verbindung der einzelnen Anschlüsse des Busses notwendigen Leiter für verschiedene Busse in verschiedene Ebenen der Schaltplatine verlegt, wobei gem. einer vorteilhaften Weiterbildung die einzelnen Leitungen untereinander aber auch die einzelnen Ebenen untereinander durch zusätzliche metallische Zwischenlagen gegenseitig abgeschirmt werden, wobei praktisch jegliches Nebensprechen unterbunden wird.

Wenn dann gem. einer Weiterbildung des Erfindungsgedankens die Leiter einzelner Leiterlagen seitlich bis an den Rand der Platine geführt und dort mit Teilen einer Steckverbindung, also mit einer Buchse oder aber mit einem Stecker verbunden werden, dann kann in diesen Fällen, und zwar vorzugsweise auf der den Steckerleisten abgewandten Seite die Schaltplatine mit zusätzlichen Bauelementen zur Anpassung des Wellenwiderstandes und/oder mit Abschlußwiderständen beschaltet werden. Über diese Anschlüsse können mittels Schaltbrücken ggf. auch willkürlich Leiter untereinander aber auch überbrückend verbunden werden. Weitere Einzelheiten eines Vielfachschaltelementes nach der Erfindung ergeben sich aus der folgenden Beschreibung in Verbindung mit der anliegenden Zeichnung, auf welche in der Beschreibung Bezug genommen wird.

In dieser Zeichnung zeigen:

Fig. 1    in einer perspektivischen Ansicht schematisch die Verbindungsart von mit Mehrfachbussen beschalteten Leiterplatten,

Fig. 2    ein Vielfachschaltelement in seiner prinzipiellen Form,

Fig. 3    in einer Explosionsdarstellung eine Seitenansicht eines Vielfachelementes nach der Erfindung,

Fig. 4    die Draufsicht auf ein Vielfachschaltelement und

Fig. 5    die Ansicht eines derartigen Vielfachschaltelementes in Richtung des Pfeiles V in Fig. 4.

Bei Anfertigung der Zeichnung wurde bewußt nicht auf eine maßstabsgetreue Wiedergabe Wert gelegt, sondern es wurden die Teile, auf die es gem. der Erfindung besonders ankommt, in einem vergrößerten Maßstab wiedergegeben, um das Verständnis der Erfindung zu erleichtern.

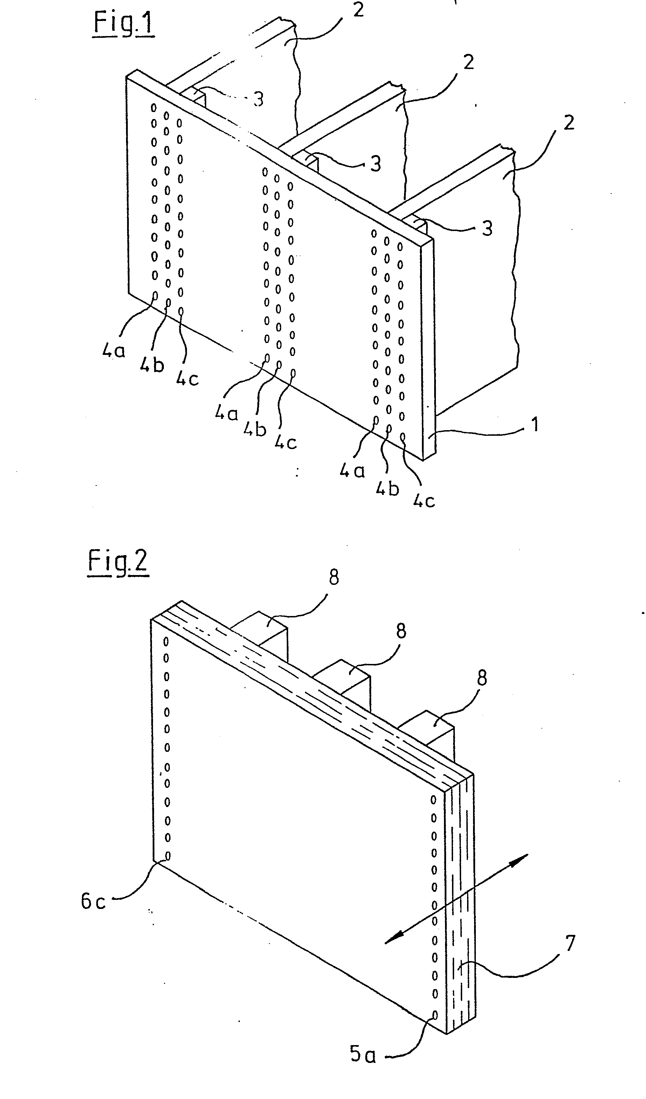

In der Fig. 1 ist mit 1 eine Verdrahtungsplatine, im Fachjargon auch backplane bezeichnet, auf deren Vorderseite die einzelnen Karten 2, insbesondere in Europa-Format eingesteckt werden. In Verbindung mit der vorliegenden Erfindung erübrigt es sich auf die besonderen Möglichkeiten und Zuordnungen einzugehen. Mit einer Verstärkung 3 ist angezeigt, daß die einzelnen Karten an ihrer Stirnfläche so ausgebildet sind, daß insgesamt 3 Reihen von Steckern entsprechend der Zuordnung von 3 Bussen eingeführt werden können.

Dabei ist angenommen, daß es sich um eine typisch busorientierte Rückwandplatine handelt, in welcher die für den Datenaustausch über jeweils den mittleren Bus geführten Informationen untereinander verbunden sind.

Die beiden äußeren Anschlußreihen hingegen werden durchgeführt und erscheinen auf der Rückseite im allgemeinen als Stecker, wobei ggf. auch in der mittleren Reihe, im Interesse einer guten Steckerführung Stecker allerdings blind angeordnet sind.

Dabei soll im folgenden der an der linken Steckerreihe 4 a angeschlossene Bus mit "a" der mittlere an sich mit der Steckerreihe 4 b nicht elektrisch verbundene Datenbus mit "b" und der rechte, an die Steckerreihe 4 c angeschlossene Bus mit "c" bezeichnet werden.

Wie schon vorstehend erwähnt, ist also der Bus b innerhalb der Rückwandplatine entsprechend verdrahtet und soweit notwendig sind an den Querverbindungsleitungen entsprechend der Standardisierung den den Pegel und Wellenwiderstand regulierende Schaltelemente, insbesondere Widerstände und Kondensatoren eingeschaltet.

Dem Anwender eines solchen Systems, bei welchem beispielsweise auf den einzelnen Karten 2 jeweils ein Mikroprozeß untergebracht sein kann, stehen die Busse a und c für seine Zwecke frei zur Verfügung. Hierzu wurde, wie einleitend erwähnt, bislang auf der Rückseite ein mit entsprechenden Steckerleisten versehenes Bandkabel aufgesetzt, über welches dann alle Stecker der Reihe 4 a untereinander sowie die Stecker der Reihen 4 c untereinander verbunden werden konnten.

Gemäß der Erfindung wird nun hier ein Vielfachschaltelement mit einem Aufbau, wie es im folgenden erläutert wird, einfach aufgesetzt. Dieses Vielfachschaltelement besteht, wie zunächst aus Fig. 2 in Übersicht zu ersehen, aus einer Schaltplatine 7, die, wie im einzelnen noch erläutert wird, mehrlagig ausgeführt ist. Diese Schaltplatine 7 trägt auf der der Rückwandplatine 1 zugewandten Seite Steckerleisten 8, in die die Stifte der Reihen 4 a bis 4 c jeweils beim Aufsetzen des Vielfachschaltelementes eingreifen und eine gute elektrische Verbindung herstellen.

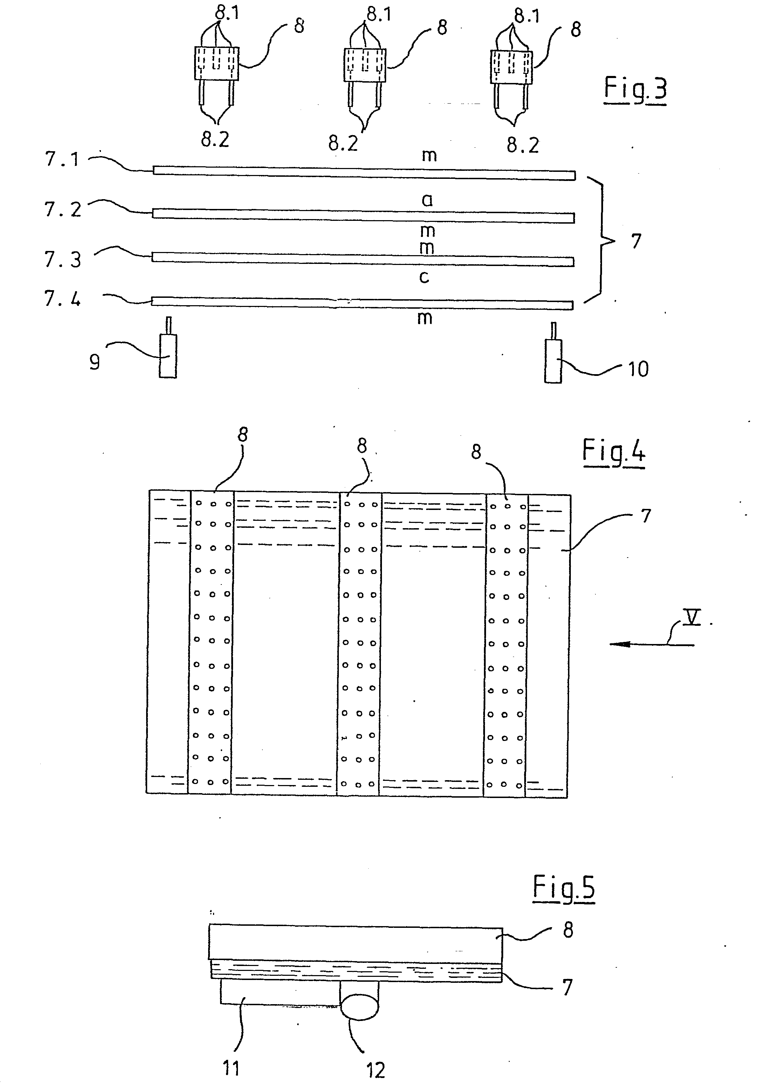

Auf der Rückseite der Schaltplatine 7 sind zusätzlich zwei Reihen von Buchsen, nämlich die Reihe 5 a und die Reihe 6 c vorgesehen. Dabei wird durch die Bezugszeichenwahl zum Ausdruck gebracht, daß die Buchsenreihe 5 mit dem Bus a in einer noch im einzelnen erläuterten Weise in Ver-bindung stehen, während die Buchsen der Reihe 6 mit dem Bus c Verbindung haben sollen. Die Fig. 3 zeigt nun in einer Explosionszeichnung den Aufbau einer derartigen Schaltplatine 7, wie sie schematisch in Fig. 2 angedeutet ist. Dabei sind in der Fig. 3 zunächst wieder die 3 Steckerleisten 8 zu sehen, die an ihrer Oberseite Buchsen 8.1 tragen, in die die Stifte der Rückwandplatine entsprechend eingeführt werden. Zur Platine 7 hin sind Kontaktstifte 8.2 vorgesehen, die in einer Reihe senkrecht zur Erstreckung der Steckerleisten 8 aber auch gegeneinander versetzt angeordnet sein können.

Die Schaltplatine 7 ist in dem gezeigten Ausführungsbeispiel aus 4 einzelnen Schichten 7.1, 7.2., 7.3 und 7.4 aufgebaut. Dabei besteht jede Schicht aus Isoliermaterial, das im Fall der ersten Schicht 7.1 auf der Oberseite m in von den Steckern freien Bereichen zur Abschirmung metallisiert ist, während die Schicht 7.2 auf der Oberseite eine Vielzahl von in der Zeichenebene verlaufenden Leitungen zur Querverbindung der Anschlußstifte des Busses a und auf der Unterseite eine Massebeschichtung m trägt. Die Schicht 7.3 ist analog in umgekehrter Richtung zur Schicht 7.2 aufgebaut, d.h. diese Schicht trägt auf der Oberseite eine Massebelegung m und auf der Unterseite Querverbindungsleiter zur Querverbindung der Anschlüsse des Busses c und die unterste Schicht 7.4 ist lediglich auf ihrer Außenseite im Interesse einer guten Abschirmung in ihren freien Bereichen metallisiert. Schon aus dieser Darstellung ist zu ersehen, daß nach dem Zusammenpacken der vier Schichten eine einwandfreie gegenseitige Abschirmung der Leitungen des Busses a gegenüber den Leitungen des Busses c sowie auch gegenüber der Umgebung garantiert ist.

Mit den schematisch dargestellten Schaltelementen 9 und 10 ist angedeutet, daß auf der Rückseite, wie schon vorstehend erwähnt, noch einzelne Bauelemente eingesteckt werden können, ohne daß hierzu besondere Fertigungsmaßnahmen notwendig wären.

Die Art der Verbindung zwischen den einzelnen Steckerstiften bzw. Buchsen wird anhand der Fig. 4 erläutert. In der Fig. 4 ist die Platine 7 von oben bei abgenommenen Steckerleisten 8 wiedergegeben. Dabei sollen die einzelnen gestrichelten Linien den Verlauf der einzelnen Leiterlagen im Inneren der Platine 7 andeuten. Es ist zu sehen, daß abwechselnd eine der Leiterlagen nach links etwas weiter herausgeführt ist und die nächste nach rechts. Dabei wird davon ausgegangen, daß beispielsweise der oberste nach links verlängerte Leiter jeweils mit dem linken oberen Kontaktstift, also dem ersten Kontakt des Busses a verbunden ist, während der nächste nach rechts hinausgezogene Leiter, der im Inneren in einer anderen Ebene, als der obere verläuft, vgl. Fig.7, mit dem rechten oberen Kontaktstift, also dem ersten Kontaktstift des Busses c verbunden ist. Diese Verteilung und Zuordnung der Leiter der verschiedenen Ebenen setzt sich über die ganze Platine fort, wodurch dann auf der linken Seite mit Einsetzen einfacher Buchsen Schaltelemente mit den Anschlüssen für den Bus a geschaffen werden können, während auf der rechten Seite durch Einprägen von Buchsen Schaltelemente mit den Kontakten des Busses c kontaktiert werden können. Dementsprechend würde man, vgl. Fig. 3, beispielsweise einen Widerstand 9, der zur Anpassung des Wellenwiderstandes für einen oder mehrerer Leiter des Busses a benötigt wird, auf der linken Seite einführen, während auf der rechten Seite beispielsweise ein Kondensator 10 mit ausgewählten Leitungen des Busses c in Kontakt gebracht werden kann.

- 8 -

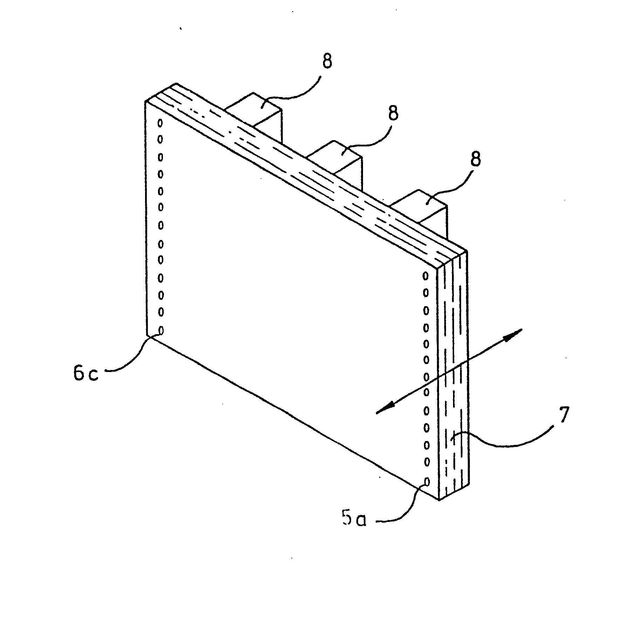

Dies wird noch anschaulich an Hand der Fig. 5 gezeigt, wo eine Platine schematisch in ihrer Seitenansicht entsprechend dem Pfeil V in Fig. 4 wiedergegeben ist. Auch hier ist die Platine mit 7 bezeichnet, auf der sich eine Steckerleiste 8 befindet. Auf der Unterseite wurde beispielsweise eine Widerstandskombination in nur angedeutete Buchsen eingesteckt, während die mittleren Leitungen beispielsweise mit einem Kondensator 12 bestückt sein sollen.

Das Vielfachschaltelement nach der Erfindung wurde vorausgehend anhand von konkreten Details, jedoch nur in einer Übersicht beschrieben. Für den auf dem Fachgebiet tätigen Fachmann ist ohne weiteres ersichtlich, daß der Erfindungsgedanke, nämlich ein festes Vielfachschaltelement, das eine einwandfreie Verdrahtung von mehreren parallel geführten Bussen mit gleichzeitiger zusätzlicher Beschaltung ermöglicht, auf verschiedene Weise abgewandelt werden kann.

So ist beispielsweise die Annahme, es müßten speziell 2 von 3 Bussen miteinander verschaltet werden, rein willkürlich. Im Rahmen der Erfindung ist es vielmehr auch möglich, nur einen von 2 Bussen entsprechend zu verbinden oder aber auch 4, wenn nur dafür gesorgt ist, daß die einzelnen durch die Rückwandplatine geführten Stecker so gegeneinander versetzt sind, daß eine entsprechende Kontaktierung mit den Querverbindungsleiterlagen ohne gegenseitige Beeinflussung möglich ist. Dabei kann die Schaltplatine 7 auch in anderer Weise als, wie beschrieben, in Sandwich-Bauweise, nämlich beispielsweise in einer Multi-Layer-Ausführung erstellt werden. Es ist auch nicht in jedem Fall notwendig, daß die Platine auf beiden Seiten metallisch belegt ist, um eine entsprechende Abschirmung zu erreichen. So kann beispielsweise die metallische Belegung auf der obersten Folie 7.1 dann entfallen, wenn die im montierten Zustand anschließende Rückwandplatine entsprechend abgeschirmt ist. Auch ist es im Rahmen der Erfindung keineswegs notwendig, daß die zusätzlich einzusteckenden Schaltelemente, wie mit den Bezugszeichen 9, 10, 11 und 12 angedeutet, unbedingt am äußeren Rand anzuordnen sind, wenngleich diese Ausbildungsform auch fertigungstechnisch besonders einfach und vorteilhaft ist. Vielmehr können diese Schaltelemente ggf. auch zwischen den Steckerleisten 8 auf der Rückseite oder aber soweit es die Abmessungen erlauben, auch auf der Vorderseite angeordnet werden. Im besonderen sei noch darauf hingewiesen, daß das Vielfachschaltelement gem. der Erfindung von ganz besonderer Bedeutung in Schaltungsanordnungen ist, wo über das Zusammenfügen von 2 Europakarten Worte aus 32 Byte parallel übertragen und damit eine zusätzliche Verschaltung von parallel angeordneten Leiterplatten notwendig wird.

Anwaltsakte: 4206

Vielfachschaltelement zum Verbinden
einer Mehrzahl von Mehrfachbussen

Patentansprüche

1. Vielfachschaltelement zum Verbinden einer Mehrzahl von insbesondere an Steckerleisten geführten und/oder durch eine Verdrahtungsplatine durchkontaktierten, parallel geführten Mehrfachbussen, von denen jeweils einer, vorzugsweise der in der Kontaktleiste bzw. der Verdrahtungsplatine in der Mitte geführte Bus entsprechend vereinbarter Standardisierung mit entsprechenden Leitungen der im Vielfach zu verknüpfenden Busse verschaltet ist und die restlichen parallel zum festverschalteten Bus geführten Anschlüsse individuell beschaltbar sind, dadurch gekennzeichnet, daß eine mehrlagige Schaltplatine (7) vorgesehen ist, die einseitig eine der Anzahl der zu verknüpfenden Mehrfachbusse entsprechende Anzahl von Steckerleisten (8) aufweist mit mindestens der Anzahl der einem Mehrfachbus zugeordneten Steckerreihen (4 a, 4 b, 4 c) und daß die Schaltplatine (7) im Inneren der Anzahl der Busse eines Mehrfachbusses minus 1 entsprechende Anzahl von Querverbindungsleiterlagen (7.2, 7.3) in unterschiedlichen Ebenen aufweist, wobei die Leiter einer Querverbindungslage mit jeweils einem der Busse eines Mehrfachbusses durchkontaktiert sind.

2. Vielfachschaltelement nach Anspruch 1, dadurch gekennzeichnet, daß die Schaltplatine (7) in Multi-Layer-Technik ausgeführt ist.

3. Vielfachschaltelement nach Anspruch 1, dadurch gekennzeichnet, daß die Schaltplatine in Sandwich-Technik ausgebildet ist (Fig. 3).

4. Vielfachschaltelement nach einem der Ansprüche 1 bis 3, dadurch gekennzeichnet, daß die einzelnen Querverbindungsleiter beidseitig seitlich bis an den Rand der Schaltplatine über die Steckerleisten (8) hinaus verlängert sind und mit je einer Buchse im Randbereich zum Einstecken von Schaltelementen zur Anpassung des Wellenwiderstandes oder dgl. verbunden sind.

5. Vielfachschaltelement nach einem der Ansprüche 1 bis 4, dadurch gekennzeichnet, daß zwischen den einzelnen Querverbindungslagen eine Abschirmung (m) vorgesehen ist.

6. Vielfachschaltelement nach einem der vorhergehenden Ansprüche, dadurch gekennzeichnet, daß zwischen die einzelnen Leiter einer Querverbindungslage zur Abschirmung Metallbelegungen, die mit Masse verbunden sind, vorgesehen sind.

Fig.1

Fig.2

0199309

2/3

Fig.3

Fig.4

Fig.5